# EUROPEAN PATENT SPECIFICATION

(11) **EP 2 615 630 B1**
(45) Date of publication and mention of the grant of the patent: **20.11.2019**
(21) Application number: 11823333.7
(22) Date of filing: 14.07.2011
(51) Int. Cl.: H01L 21/304, H01L 21/308, B81C 1/00, H01L 21/02

(54) **USE OF TREATMENT LIQUID FOR INHIBITING PATTERN COLLAPSE IN MICROSTRUCTURES, AND MICROSTRUCTURE MANUFACTURING METHOD USING SAID TREATMENT LIQUID**
VERWENDUNG VON BEHANDLUNGSFLÜSSIGKEIT ZUR HEMMUNG VON MUSTERZUSAMMENBRÜCHEN IN MIKROSTRUKTUREN UND VERFAHREN ZUR HERSTELLUNG VON MIKROSTRUKTUREN UNTER VERWENDUNG DER BEHANDLUNGSFLÜSSIGKEIT
UTILISATION D'UN LIQUIDE DE TRAITEMENT SERVANT À INHIBER LES AFFAISSEMENTS DE MOTIFS DANS LES MICROSTRUCTURES, ET PROCÉDÉ DE FABRICATION DE MICROSTRUCTURES UTILISANT LEDIT LIQUIDE DE TRAITEMENT

(30) Priority: 08.09.2010 JP 2010200781
(43) Date of publication of application: 17.07.2013
(73) Proprietor: Mitsubishi Gas Chemical Company, Inc., Tokyo 100-8324 (JP)
(72) Inventor: MATSUNAGA, Hiroshi, Tokyo 125-0051 (JP); OHTO, Masaru, Tokyo 125-0051 (JP)
(74) Representative: Müller-Boré & Partner Patentanwälte PartG mbB
(86) International application number: PCT/JP2011/066156
(87) International publication number: WO 2012/032854

(56) References cited:
- EP-A1- 1 818 723
- EP-A2- 1 106 946
- JP-A- 2009 088 253
- US-A1- 2009 084 754

## Description

The present invention relates to the use of a processing liquid for suppressing pattern collapse of a microstructure, and a method for producing a microstructure using the processing liquid.

The photolithography technique has been employed as a formation and processing method of a device having a microstructure used in a wide range of fields of art including a semiconductor device, a circuit board and the like. In these fields of art, reduction of size, increase of integration degree and increase of speed of a semiconductor device considerably proceed associated with the highly sophisticated demands on capabilities, which bring about continuous miniaturization and increase of aspect ratio of a resist pattern used for photolithography. However, the progress of miniaturization of the resist pattern causes pattern collapse as a major problem.

It has been known that upon drying the resist pattern to remove a processing liquid used in wet processing (which is mainly a rinsing treatment for washing away a developer solution) therefrom after developing the resist pattern, the collapse of the resist pattern is caused by the stress derived by the surface tension of the processing liquid. For preventing the collapse of the resist pattern, such methods have been proposed as a method of replacing the rinsing liquid by a liquid having a low surface tension using a nonionic surfactant, a compound soluble in an alcohol solvent, or the like (see, for example, Patent Documents 1 and 2), and a method of hydrophobizing the surface of the resist pattern (see, for example, Patent Document 3).

In a microstructure formed of a metal, a metal nitride, a metal oxide, a silicon oxide, silicon or the like (except for a resist; hereinafter defined in the same way unless otherwise specified) by the photolithography technique, the strength of the material itself constituting the structure is larger than the strength of the resist pattern itself or the bonding strength between the resist pattern and the substrate, and therefore, the collapse of the structure pattern is hard to occur as compared to the resist pattern. However, associated with the progress of reduction of size, increase of integration degree and increase of speed of a semiconductor device and a micromachine, the pattern collapse of the structure is becoming a major problem due to miniaturization and increase of aspect ratio of the pattern.

Under these circumstances, in order to solve the problem of pattern collapse of the microstructure, there has been proposed the method of forming a hydrophobic protective film using a surfactant (see, for example, Patent Document 4). However, in Patent Document 4, there are no descriptions concerning details of the surfactant including kind (nonionic, anionic or cationic, etc.), product names, concentrations or the like.

Patent Document 1: JP-A-2004-184648
Patent Document 2: JP-A-2005-309260
Patent Document 3: JP-A-2006-163314
Patent Document 4: JP-A-2010-114467

US 2009/084754 A1, see in particular paragraph [0031] discloses the use of Surflon S121 in rinsing to avoid pattern collapse.

EP1 818 723 A1 discloses the compound Surflon S-141 which is a fluoralkyl group containing ammonium oxide compound. EP1 818 723 A1 is silent on the use of S-141 in a rinsing composition (it rather relates to antireflection film-forming composition).

As described above, the current situation is that no effective technique for suppressing pattern collapse has been known in the field of microstructures (in particular, microstructures formed of silicon oxide) such as a semiconductor device and a micromachine.

The present invention has been developed under the circumstances, and an object thereof is to provide a processing liquid that is capable of suppressing pattern collapse of a microstructure formed of silicon oxide, such as a semiconductor device and a micromachine, and a method for producing a microstructure using the processing liquid.

As a result of earnest investigations made by the inventors for achieving the object, it has been found that the object can be achieved when using a processing liquid including a fluoroalkyl group-containing amine oxide compound and water.

The present invention has been accomplished on the basis of the above finding. Accordingly, the present invention relates to the following aspects.

1. Use of a processing liquid for suppressing pattern collapse of a microstructure formed of silicon oxide, wherein the processing liquid comprises a fluoroalkyl group-containing amine oxide compound and water; and the microstructure is rinsed with the processing liquid.
2. The use as described in the above aspect 1, wherein the content of the fluoroalkyl group-containing amine oxide compound in the processing liquid is from 10 ppm to 30%.
3. The use as described in the above aspect 1 or 2, wherein the fluoroalkyl group is a perfluoroalkyl group having 1 to 6 carbon atoms.
4. A method for producing a microstructure formed of silicon oxide, comprising the steps of:
   subjecting a structure to wet etching or dry etching to obtain the microstructure;
   rinsing the microstructure obtained by the wet etching or dry etching with a processing liquid for suppressing pattern collapse of the microstructure, the processing liquid comprising a fluoroalkyl group-containing amine oxide compound and water; and
   drying the microstructure.
5. The method as described in the above aspect 4, wherein the microstructure is a semiconductor device or a micromachine.

According to the present invention, there are provided the use of a processing liquid that is capable of suppressing pattern collapse of a microstructure formed of silicon oxide, such as a semiconductor device and a micromachine, and a method for producing a microstructure using the processing liquid.

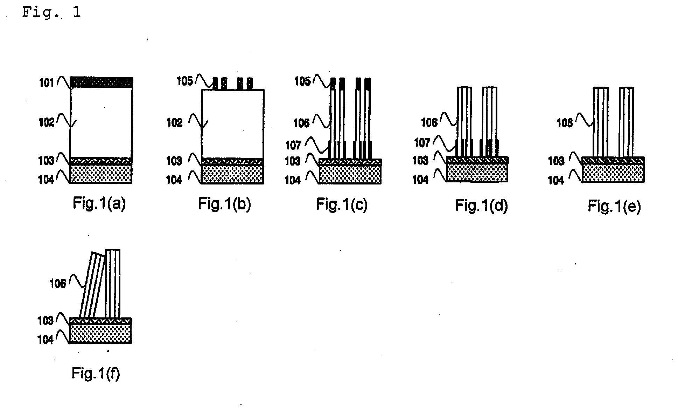

FIG. 1(a) to FIG. 1(f) are schematic cross sectional views showing respective production steps of a microstructure.

### (Use of processing Liquid for Suppressing Pattern Collapse)

The processing liquid used in the present invention (i.e., a processing liquid for suppressing pattern collapse) is used for suppressing pattern collapse of a microstructure formed of silicon oxide, and comprises a fluoroalkyl group-containing amine oxide compound and water.

The term "microstructure formed of silicon oxide" as used herein means a microstructure in which a portion to be processed with the processing liquid is formed of silicon oxide.

It is considered that the fluoroalkyl group-containing amine oxide compound used in the processing liquid used in the present invention is adsorbed to the silicon oxide used in the pattern of the microstructure, thereby hydrophobizing the surface of the pattern. The hydrophobization as used in the present invention means that the contact angle of the silicon oxide having been processed with the processing liquid used in the present invention with respect to water is 70° or more.

In addition, the fluoroalkyl group as used in the present invention means an alkyl group containing a carbon atom to which at least one fluorine atom is bonded. As the fluoroalkyl group, there may be suitably used perfluoroalkyl groups having 1 to 6 carbon atoms. In view of practical use, among these perfluoroalkyl groups, most preferred is a perfluoroalkyl group having 6 carbon atoms.

In general, examples of a fluoroalkyl group-containing ammonium halide include "Fluorad FC-135" (product name) available from Sumitomo 3M Ltd., "Ftergent 300" (product name) available from NEOS Co., Ltd., "Ftergent 310" (product name) available from NEOS Co., Ltd., "Surflon S-121" (product name) available from AGC Seimi Chemical Co., Ltd., and "Surflon S-221" (product name) available from AGC Seimi Chemical Co., Ltd. Among these fluoroalkyl group-containing ammonium halides, in general preferred is "Surflon S-221" (product name) available from AGC Seimi Chemical Co., Ltd.

In general, examples of a fluoroalkyl group-containing betaine compound include "Ftergent 400S" (product name) available from NEOS Co., Ltd., "Surflon S-131" (product name) available from AGC Seimi Chemical Co., Ltd., "Surflon S-132" (product name) available from AGC Seimi Chemical Co., Ltd., and "Surflon S-231" (product name) available from AGC Seimi Chemical Co., Ltd. Among these fluoroalkyl group-containing betaine compounds, in general preferred is "Surflon S-231" available from AGC Seimi Chemical Co., Ltd.

Preferred examples of the fluoroalkyl group-containing amine oxide compound include "Surflon S-141" (product name) available from AGC Seimi Chemical Co., Ltd., and "Surflon S-241" (product name) available from AGC Seimi Chemical Co., Ltd. Among these fluoroalkyl group-containing amine oxide compounds, especially preferred is "Surflon S-241" (product name) available from AGC Seimi Chemical Co., Ltd.

The processing liquid used in the present invention may be used in the form of an aqueous solution. Preferred examples of the water used for preparation of the aqueous solution include water, from which metallic ions, organic impurities, particles and the like are removed by distillation, ion exchange, filtering, adsorption treatment or the like, and particularly preferred examples thereof include pure water and ultrapure water.

The processing liquid used in the present invention comprises the fluoroalkyl group-containing amine oxide compound and water, and may also contain various kinds of additives that are ordinarily used in processing liquids in such a range that does not impair the advantages of using the processing liquid.

The content of the fluoroalkyl group-containing amine oxide compound in the processing liquid used in the present invention is preferably from 10 ppm to 30%, more preferably from 10 ppm to 20%, still more preferably from 10 ppm to 10%, especially preferably from 10 to 2,000 ppm, and most preferably from 10 to 1,000 ppm. In the case where the compounds do not have sufficient solubility in water to cause phase separation, an organic solvent, such as an alcohol, may be added, and an acid or an alkali may be added to enhance the solubility. Even in the case where the processing liquid is simply turbid white without phase separation, the processing liquid may be used in such a range that does not impair the advantages of the processing liquid, and may be used while stirring to render the processing liquid homogeneous. Furthermore, for avoiding the white turbidity of the processing liquid, the processing liquid may be used after adding an organic solvent, such as an alcohol, an acid or an alkali thereto as similar to the above case.

The processing liquid used in the present invention is suitably used for suppressing pattern collapse of a microstructure, such as a semiconductor device and a micromachine. Preferred examples of the pattern of the microstructure include those patterns obtained from silicon oxide.

The microstructure may be patterned on an insulating film species, such as TEOS (a tetraethoxy ortho silane oxide film) and SiOC-based low dielectric constant films (such as "Black Diamond 2" (tradename) available from Applied Materials Inc., and "Aurora 2.7" and "Aurora 2.4" (tradenames) both available from ASM International N.V.), in some cases, or the insulating film species may be contained as a part of the microstructure in some cases.

The processing liquid used in the present invention can exhibit excellent pattern collapse suppressing effect to not only an ordinary microstructure, but also a microstructure with further miniaturization and higher aspect ratio. The aspect ratio as referred herein is a value calculated from (height of pattern/width of pattern), and the processing liquid used in the present invention may exhibit excellent pattern collapse suppressing effect to a pattern that has a high aspect ratio of 3 or more, and further 7 or more. The processing liquid used in the present invention has excellent pattern collapse suppressing effect to a finer pattern with a pattern size (pattern width) of 300 nm or less, further 150 nm or less, and still further 100 nm or less, and with a pattern size of 50 nm or less and a line/space ratio of 1/1, and similarly to a finer pattern with a pattern distance of 300 nm or less, further 150 nm or less, still further 100 nm or less, and still further 50 nm or less and a cylindrical hollow or cylindrical solid structure.

### [Method for Producing Microstructure]

The method for producing a microstructure formed of silicon oxide according to the present invention includes, after wet etching or dry etching, a rinsing step using the processing liquid used in the present invention. More specifically, in the rinsing step, it is preferred that the pattern of the microstructure is made in contact with the processing liquid used in the present invention by dipping, spray ejecting, spraying or the like, then the processing liquid is replaced by water, and the microstructure is dried. In the case where the pattern of the microstructure and the processing liquid used in the present invention are in contact with each other by dipping, the dipping time is preferably from 10 seconds to 30 minutes, more preferably from 15 seconds to 20 minutes, still more preferably from 20 seconds to 15 minutes, and especially preferably from 30 seconds to 10 minutes, and the temperature condition is preferably from 10 to 80°C, more preferably from 15 to 60°C, still more preferably from 25 to 50°C, and especially preferably from 25 to 40°C. The pattern of the microstructure may be rinsed with water before making in contact with the processing liquid used in the present invention. The contact between the pattern of the microstructure and the processing liquid used in the present invention enables suppression of collapse of the pattern through hydrophobization of the surface of the pattern.

The processing liquid used in the present invention may be applied widely to a production process of a microstructure irrespective of the kind of microstructure, with the production process having a step of wet etching or dry etching, then a step of wet processing (such as etching, cleaning or rinsing for washing away the cleaning liquid), and then a drying step. For example, the processing liquid used in the present invention may be suitably used after the etching step in the production process of a semiconductor device or a micromachine, for example, (i) after wet etching of an insulating film around an electroconductive film in the production of a DRAM type semiconductor device (see, for example, JP-A-2000-196038 and JP-A-2004-288710), (ii) after a rinsing step for removing contamination formed after dry etching or wet etching upon processing a gate electrode in the production of a semiconductor device having a transistor with a fin in the form of strips (see, for example, JP-A-2007-335892), and (iii) after a rinsing step for removing contamination formed after etching for forming a cavity by removing a sacrifice layer formed of an insulating film through a through hole in an electroconductive film upon forming a cavity of a micromachine (electrodynamic micromachine) (see, for example, JP-A-2009-122031).

### EXAMPLES

The present invention will be described in more detail with reference to Examples, etc., below, but the present invention is not limited to these Examples.

In order to illustrate the present invention, reference is made to the following drawings in which:
figures 1(a)-1(e) show an embodiment of the method of the invention;
figure 1(f) shows a comparative example not forming part of the invention.

### <<Preparation of Processing Liquid>>

Processing liquids for suppressing pattern collapse of a microstructure were prepared according to the formulation compositions (% by mass) as shown in Table 1.

**TABLE 1**

| | Kind | Content |
|---|---|---|
| Processing liquid 1 | Surflon S-221*¹ | 5% |
| Processing liquid 2 | Surflon S-221*¹ | 2,000 ppm |
| Processing liquid 3 | Surflon S-221*¹ | 10 ppm |
| Processing liquid 4 | Surflon S-231*² | 10% |
| Processing liquid 5 | Surflon S-231*² | 1,000 ppm |
| Processing liquid 6 | Surflon S-231*² | 100 ppm |
| Processing liquid 7 | Surflon S-241*³ | 30% |
| Processing liquid 8 | Surflon S-241*³ | 5,000 ppm |
| Processing liquid 9 | Surflon S-241*³ | 50 ppm |

| | | |
|---|---|---|
| *1: "Surflon S-221" (tradename) available from AGC Seimi Chemical Co., Ltd.; perfluoroalkyl trialkyl ammonium halide (number of carbon atoms in alkyl group: 6); specific gravity: 1.07 (25°C); viscosity: 6.7 mPa•s (25°C); pH: 8.0 to 10.0; surface tension: 15.8 mN/m (0.1% aqueous solution, 25°C); flash point: 21°C (as measured by a tag closed cup method) *2: "Surflon S-231" (tradename) available from AGC Seimi Chemical Co., Ltd.; perfluoroalkyl betaine (number of carbon atoms in alkyl group: 6); specific gravity: 1.00 (25°C); viscosity: 9.1 mPa•s (25°C); pH: 6.3 to 8.3; surface tension: 17.5 mN/m (0.1% aqueous solution, 25°C); flash point: 17°C (as measured by a tag closed cup method) *3: "Surflon S-241" (tradename) available from AGC Seimi Chemical Co., Ltd.; perfluoroalkyl amine oxide (number of carbon atoms in alkyl group: 6); specific gravity: 1.04 (25°C); viscosity: 9.9 mPa•s (25°C); pH: 7.8 to 9.8; surface tension: 16.2 mN/m (0.1% aqueous solution, 25°C); flash point: 20°C (as measured by a tag closed cup method) | | |

### Examples 7 to 9 and Reference Examples 1 to 6

As shown in FIG. 1(a), silicon nitride 103 (thickness: 100 nm) and silicon oxide 102 (thickness: 1,200 nm) were formed as films on a silicon substrate 104, then a photoresist 101 was formed, and the photoresist 101 was exposed and developed, thereby forming a tubular (chimney-shaped) photoresist 105 (diameter: 125 nm, distance between circles: 50 nm), as shown in FIG. 1(b). The silicon oxide 102 was etched by dry etching with the photoresist 105 as a mask, thereby forming a cylindrical hollow 106 reaching the layer of silicon nitride 103, as shown in FIG. 1(c). Upon the dry etching, etching residues 107 remained both inside and outside of the cylindrical hollow. The photoresist 105 was then removed by ashing, thereby providing a structure having the silicon oxide 102 with the cylindrical hollow 106 reaching the layer of silicon nitride 103, as shown in FIG. 1(d). The etching residues 107 of the resulting structure were removed by dissolving with a 0.1 wt% hydrofluoric acid aqueous solution (by dipping at 25°C for 30 seconds), and then the structure was successively processed by making into contact with pure water, the respective processing liquids 1 to 9 (see Table 1; by dipping at 30°C for 10 minutes), and pure water in this order, followed by drying, thereby providing a structure shown in FIG. 1(e).

The resulting structure had a microstructure with a tubular (chimney-shaped) pattern of the silicon oxide (diameter: 125 nm, height: 1,200 nm (aspect ratio: 9.6), distance between the cylindrical hollows: 50 nm), and 70% or more of the pattern was not collapsed.

The pattern collapse was observed with "FE-SEM S-5500 (model number)", produced by Hitachi High-Technologies Corporation, and the collapse suppression ratio was a value obtained by calculating the ratio of the not-collapsed pattern in the total pattern. Cases where the collapse suppression ratio was 50% or more were determined as "passed". The processing liquids, the processing methods and the results of collapse suppression ratios in the respective Examples are shown in Table 3.

### Comparative Example 1

The same procedure as in Example 1 was repeated except that after removing the etching residues 107 of the structure as shown in FIG. 1(d) by dissolving with a 0.1 wt% hydrofluoric acid aqueous solution (by dipping at 25°C for 30 seconds), the structure was processed only with pure water. As a result, 50% or more of the pattern of the resulting structure were collapsed as shown in FIG. 1(f) (which indicated a collapse suppression ratio of less than 50%). The processing liquid, the processing method and the result of collapse suppression ratio in Comparative Example 1 are shown in Table 3.

### Comparative Examples 2 to 11

The same procedure as in Example 1 was repeated except that after removing the etching residues 107 of the structures as shown in FIG. 1(d) by dissolving with a 0.1 wt% hydrofluoric acid aqueous solution and then processing the structures with pure water, the structures were processed with the respective comparative liquids 2 to 11 shown in Table 2 instead of the processing liquid 1. As a result, 50% or more of the pattern of the resulting respective structures were collapsed as shown in FIG. 1(f). The processing liquids, the processing methods and the results of collapse suppression ratios in Comparative Examples 2 to 11 are shown in Table 3.

**TABLE 2**

| | Name of substance |
|---|---|
| Comparative Example 1 | Water |
| Comparative liquid 2 | Isopropyl alcohol |
| Comparative liquid 3 | Diethylene glycol monomethyl ether |
| Comparative liquid 4 | Dimethyl acetamide |
| Comparative liquid 5 | Ammonium perfluoroalkyl sulfonate halide*¹ |
| Comparative liquid 6 | Perfluoroalkyl carboxylic acid salt*² |
| Comparative liquid 7 | Adduct of perfluoroalkyl with ethyleneoxide*³ |
| Comparative liquid 8 | Adduct of 2,4,7,9-tetramethyl-5-decyne-4,7-diol with ethyleneoxide*⁴ |
| Comparative liquid 9 | 2,4,7,9-Tetramethyl-5-decyne-4,7-diol*⁵ |
| Comparative liquid 10 | Dodecyl trimethyl ammonium chloride (number of carbon atoms in alkyl group: 12)*⁶ |
| Comparative liquid 11 | Polyoxyethylene/polyoxypropylene block polymer*⁷ |

| | |
|---|---|
| *1: "Fluorad FC-93" (tradename) available from 3M Corp.; specific gravity: 1.1 (25°C); pH: 7 (0.1% aqueous solution); flash point: 38°C (as measured by an open cup method); 0.01% aqueous solution *2: "Surflon S-111" (tradename) available from AGC Seimi Chemical Co., Ltd.; specific gravity: 1.0 (20°C); flash point: 18°C (as measured by a tag closed cup method); 0.01% aqueous solution *3: "Surflon S-242" (tradename) available from AGC Seimi Chemical Co., Ltd.; surface tension: 18.1 mN/m (0.1% aqueous solution; 25°C); flash point: 247°C (as measured by a Cleveland open cup method); 0.01% aqueous solution *4: "Surfynol 420" (tradename) available from Nisshin Chemical Industry Co., Ltd.; ethyleneoxide content: 20%; 0.01% aqueous solution *5: "Surfynol 104" (tradename) available from Nisshin Chemical Industry Co., Ltd.; 0.01% aqueous solution *6: "Catiogen TML" (tradename) available from Dai-ichi Kogyo Seiyaku Co., Ltd.; 0.01% aqueous solution *7: "Epan 420" (tradename) available from Dai-ichi Kogyo Seiyaku Co., Ltd.; average molecular weight of a hydrophobic group (polyoxypropylene): 1,200; polyoxyethylene content: 20%; 0.01% aqueous solution | |

**TABLE 3**

| | Processing method | Collapse suppression ratio*¹ | Pass or fail |
|---|---|---|---|
| Reference Example 1 | Pure water → processing liquid 1 → pure water → drying | 80% or more | Pass |
| Reference Example 2 | Pure water → processing liquid 2 → pure water → drying | 80% or more | Pass |
| Reference Example 3 | Pure water → processing liquid 3 → pure water → drying | 70% or more | Pass |
| Reference Example 4 | Pure water → processing liquid 4 → pure water → drying | 80% or more | Pass |
| Reference Example 5 | Pure water → processing liquid 5 → pure water → drying | 80% or more | Pass |
| Reference Example 6 | Pure water → processing liquid 6 → pure water → drying | 80% or more | Pass |
| Example 7 | Pure water → processing liquid 7 → pure water → drying | 80% or more | Pass |
| Example 8 | Pure water → processing liquid 8 → pure water → drying | 70% or more | Pass |
| Example 9 | Pure water → processing liquid 9 → pure water → drying | 70% or more | Pass |
| Comparative Example 1 | Pure water → drying | Less than 50% | Fail |
| Comparative Example 2 | Pure water → comparative liquid 2 → pure water → drying | Less than 50% | Fail |
| Comparative Example 3 | Pure water → comparative liquid 3 → pure water → drying | Less than 50% | Fail |
| Comparative Example 4 | Pure water → comparative liquid 4 → pure water → drying | Less than 50% | Fail |
| Comparative Example 5 | Pure water → comparative liquid 5 → pure water → drying | Less than 50% | Fail |
| Comparative Example 6 | Pure water → comparative liquid 6 → pure water → drying | Less than 50% | Fail |
| Comparative Example 7 | Pure water → comparative liquid 7 → pure water → drying | Less than 50% | Fail |
| Comparative Example 8 | Pure water → comparative liquid 8 → pure water → drying | Less than 50% | Fail |
| Comparative Example 9 | Pure water → comparative liquid 9 → pure water → drying | Less than 50% | Fail |
| Comparative Example 10 | Pure water → comparative liquid 10 → pure water → drying | Less than 50% | Fail |
| Comparative Example 11 | Pure water → comparative liquid 11 → pure water → drying | Less than 50% | Fail |

| | | | |
|---|---|---|---|
| *1: Collapse suppression ratio = [(number of cylindrical hollows not collapsed)/(total number of cylindrical hollows)] x100 (%) | | | |

The processing liquid used in the present invention is suitably used for suppressing pattern collapse upon production of a microstructure formed of silicon oxide, such as a semiconductor device and a micromachine (MEMS).

### Explanation of Reference Numerals

101: Photoresist; 102: Silicon oxide; 103: Silicon nitride; 104: Silicon substrate; 105: Circular photoresist; 106: Cylindrical hollow (silicone oxide); 107: Etching residues

## Claims

1. Use of a processing liquid for suppressing pattern collapse of a microstructure during drying after rinsing the microstructure with the processing liquid, wherein the microstructure is formed of silicon oxide, and wherein the processing liquid comprises a fluoroalkyl group-containing amine oxide compound and water.

2. The use according to claim 1, wherein a content of the fluoroalkyl group-containing amine oxide compound in the processing liquid is from 10 ppm to 30%.

3. The use according to claim 1 or 2, wherein the fluoroalkyl group is a perfluoroalkyl group having 1 to 6 carbon atoms.

4. A method for producing a microstructure formed of silicon oxide, comprising the steps of:
subjecting a structure to wet etching or dry etching to obtain the microstructure;
rinsing the microstructure obtained by the wet etching or dry etching with a processing liquid for suppressing pattern collapse of the microstructure, the processing liquid comprising a fluoroalkyl group-containing amine oxide compound and water; and
drying the microstructure.

5. The method according to claim 4, wherein the microstructure is a semiconductor device or a micromachine.

## Patentansprüche

1. Verwendung einer Bearbeitungsflüssigkeit zum Unterdrücken eines Musterzusammenbruchs einer Mikrostruktur während des Trocknens nach dem Spülen der Mikrostruktur mit der Bearbeitungsflüssigkeit, wobei die Mikrostruktur aus Siliziumoxid gebildet ist und
wobei die Bearbeitungsflüssigkeit eine fluoralkylgruppenhaltige Aminoxidverbindung und Wasser umfasst.

2. Verwendung nach Anspruch 1, wobei ein Gehalt der fluoralkylgruppenhaltigen Aminoxidverbindung in der Bearbeitungsflüssigkeit von 10 ppm bis 30% beträgt.

3. Verwendung nach Anspruch 1 oder 2, wobei die Fluoralkylgruppe eine Perfluoralkylgruppe mit 1 bis 6 Kohlenstoffatomen ist.

4. Verfahren zur Herstellung einer aus Siliziumoxid gebildeten Mikrostruktur, umfassend die Schritte:
des Unterziehens einer Struktur einer Nassätzung oder einer Trockenätzung, um die Mikrostruktur zu erhalten;
des Spülens der Mikrostruktur, erhalten durch das Nassätzen oder Trockenätzen, mit einer Bearbeitungsflüssigkeit zum Unterdrücken eines Musterzusammenbruchs der Mikrostruktur, wobei die Bearbeitungsflüssigkeit eine fluoralkylgruppenhaltige Aminoxidverbindung und Wasser umfasst; und
des Trocknens der Mikrostruktur.

5. Verfahren nach Anspruch 4, wobei die Mikrostruktur eine Halbleitervorrichtung oder eine Mikromaschine ist.

## Revendications

1. Utilisation d'un liquide de traitement pour supprimer l'affaissement de motifs d'une microstructure pendant le séchage après rinçage de la microstructure avec le liquide de traitement, dans laquelle la microstructure est constituée d'oxyde de silicium, et dans laquelle le liquide de traitement comprend un composé d'amine-oxyde contenant un groupement fluoroalkyle, et de l'eau.

2. Utilisation selon la revendication 1, dans laquelle la teneur en composé d'amine-oxyde contenant un groupement fluoroalkyle dans le liquide de traitement va de 10 ppm à 30%.

3. Utilisation selon la revendication 1 ou 2, dans laquelle le groupement fluoroalkyle est un groupement perfluoroalkyle ayant de 1 à 6 atomes de carbone.

4. Procédé de production d'une microstructure formée d'oxyde de silicium, comprenant les étapes suivantes où:
on soumet une structure à une gravure humide ou une gravure sèche pour obtenir la microstructure;
on rince la microstructure obtenue par la gravure humide ou gravure sèche avec un liquide de traitement pour supprimer l'affaissement de motifs de la microstructure, la liquide de traitement comprenant un composé d'amine-oxyde contenant un groupement fluoroalkyle et de l'eau; et
on sèche la microstructure.

5. Procédé selon la revendication 4, dans lequel la microstructure est un dispositif à semi-conducteur ou une micromachine.
